# EUROPÄISCHE PATENTSCHRIFT

(11) **EP 1 748 563 B1**
(45) Veröffentlichungstag und Bekanntmachung des Hinweises auf die Patenterteilung: **29.10.2008**
(21) Anmeldenummer: 06014104.1
(22) Anmeldetag: 07.07.2006
(51) Int. Cl.: H03M 1/06, H03M 1/74

(54) **Linearisierungs-Schaltungsanordnung und Linearisierungs-Verfahren mit digitaler Element-Anpassung für Digital-Analog-Umsetzer**
Linearising circuit and method with digital element matching for digital-to-analogue converters
Circuit et procédé de linéarisation avec adaptation numérique des éléments pour les convertisseurs numériques-analogiques

(30) Priorität: 25.07.2005 DE 102005035225
(43) Veröffentlichungstag der Anmeldung: 31.01.2007
(73) Patentinhaber: Micronas GmbH, 79008 Freiburg (DE)
(72) Erfinder: Lücking, Dieter, 79110 Freiburg (DE); Noeske, Carsten, 79350 Sexau (DE)
(74) Vertreter: Göhring, Robert

(56) Entgegenhaltungen:
- US-B1- 6 384 761

## Beschreibung

Die Erfindung bezieht sich auf eine Linearisierungs-Schaltungsanordnung mit digitaler Element-Anpassung für Digital-Analog-Umsetzer gemäß den oberbegrifflichen Merkmalen des Patentanspruchs 1 bzw. auf ein Linearisierungs-Verfahren mit digitaler Element-Anpassung für Digital-Analog-Umsetzer mit den oberbegrifflichen Merkmalen des Patentanspruchs 10.

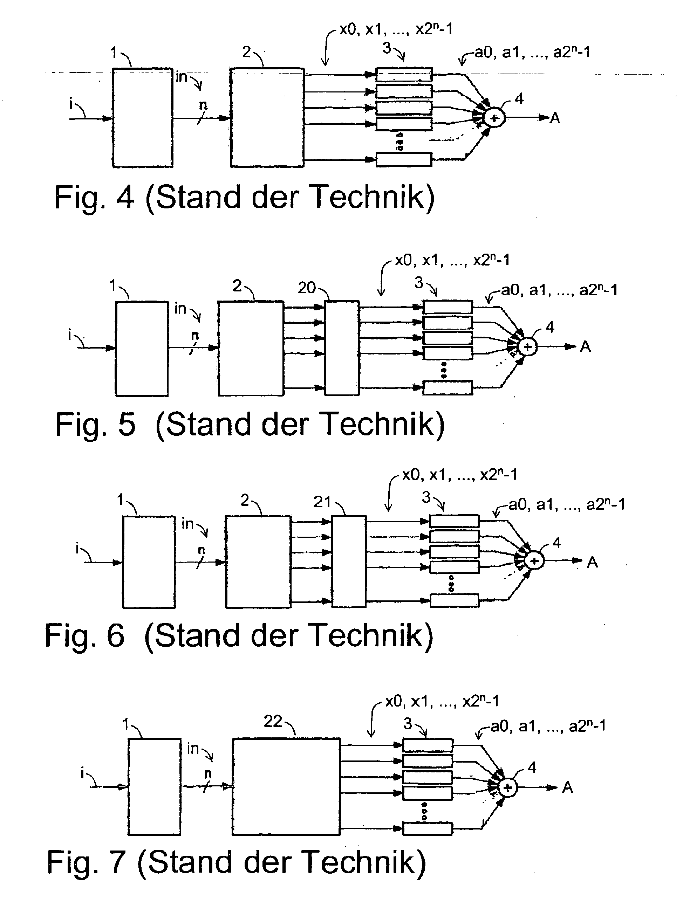

Eine Linearisierungs-Schaltungsanordnung bzw. ein Linearisierungs-Verfahren mit digitaler Element-Anpassung dient zum Kompensieren von Anpassungsfehlern (mismatch errors) in Mehr-Bit-Digital-zu-Analog-Umsetzern. Fig. 4 stellt eine allgemein bekannte Architektur eines Digital-zu-Analog-Umsetzers (DAC) dar. Ein n-Bit-Delta-Sigma-Modulator 1, an dessen Eingang ein digitales Eingangssignal i anliegt, gibt an seinem Ausgang ein moduliertes n-Bit-Signal in mit einer Gesamtanzahl n von Bit aus. Dieses modulierte n-Bit-Signal in ist einem Eingang eines Thermometer-Codierers als einem Codierer 2 angelegt. Der Codierer 2 erzeugt ein 2ⁿ-1-Bit-Signal als ein höherwertiges codiertes Signal X mit 2ⁿ-1 Signalkomponenten x0, x1, x2, ..., x2ⁿ-1, welche auf entsprechenden Ausgangsleitungen bereitgestellt werden. Jede der Ausgangsleitungen führt zu einem eigenen 1-Bit-Digital-zu-Analog-Umsetzer-Element 3, welches den Wert der eingangsseitigen Signalkomponente des höherwertigen codierten Signals X in eine entsprechende analoge Signalkomponente a0, a1, a2, ..., a2ⁿ-1 umsetzt und über einen Ausgang einem Addierer bzw. Akkumulator 4 anlegt. Der Akkumulator 4 addiert die anliegenden analogen Signalkomponenten a0, a1, ..., a2ⁿ-1 zu einem analogen Ausgangssignal A, welches aus der Schaltungsanordnung ausgegeben wird.

Bei einer solchen Anordnung steuert jedes Bit bzw. jede codierte Signalkomponente x0, x1, ..., x2ⁿ-1 somit die Aktivierung von einem der 1-Bit-Digital-zu-Analog-Umsetzer-Elemente 3. Falls alle der 1-Bit-Digital-zu-Analog-Umsetzer-Elemente 3 exakt die gleiche Wichtung hätten, würde das summierte analoge Ausgangssignal A exakt einer analogen Repräsentation des digitalen Eingangssignals i bzw. des modulierten n-Bit-Signals in am Eingang des Codierers 2 entsprechen. In einer tatsächlichen VLSI-Implementierung (VLSI: Very Large Scale Integration/sehr groß skalierte Integration), das heißt in einem Halbleiter mit integrierten Schaltungen aus einer sehr großen Anzahl logischer Elemente oder Speicherzellen, unterscheidet sich jedoch jedes der 1-Bit-Digital-zu-Analog-Umsetzer-Elemente 3 von den anderen aufgrund einer Element-Fehlanpassung. Typische Fehlanpassungs-Fehler liegen in der Größenordnung von 1 ... 2% rms. Dies verursacht eine starke Nicht-Linearität, welche zu einer Verschlechterung des Signal-zu-Rausch-Verhältnisses (SNR: Signal-to-Noise-Ratio) führt. Vor allem in Audio-Anwendungen, bei denen das Signal-zu-Rausch-Verhältnis bei 96dB und darüber hinaus liegen muss, um CD-Qualität zu erzielen, muss der Effekt der Fehlanpassung ausgeglichen werden. Dieser Ausgleich (Equalization) wird als digitale Element-Anpassung (DEM: Dynamic Element Matching) bezeichnet.

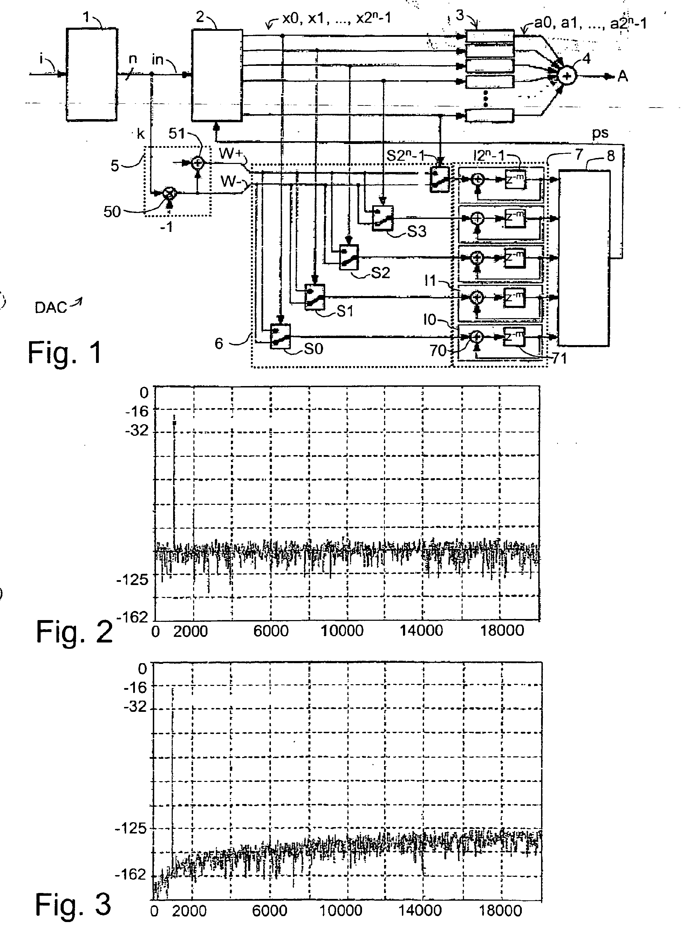

Fig. 5 zeigt eine bekannte Schaltungsanordnung zur digitale Element-Anpassung mit einem Aufbau wie bei der Schaltungsanordnung gemäß Fig.1. Jedoch ist zwischen den Codierer 2 und die 1-Bit-Digital-zu-Analog-Umsetzer-Elemente 3 eine Anordnung zur zyklischen Rotation 20 geschaltet. Damit wird verfahrensgemäß jedes der 1-Bit-Digital-zu-Analog-Umsetzer-Elemente 3 zumindest einmal für ein ausgegebenes thermometer-codiertes Signal des Codierers 2 verwendet. Dies kann durch eine Rotation der codierten Signalkomponenten x0, x1, ..., x2ⁿ-1 mit dem 2ⁿ-1-fachen der Taktrate des Delta-Sigma-Modulators 1 durchgeführt werden. Die Rotation kann beispielsweise unter Verwendung eines sogenannten Barrel-Shifters (Umwälz-Verschiebungseinrichtung) durchgeführt werden.

Fig. 6 zeigt eine weitere beispielhafte Schaltungsanordnung zur digitale Element-Anpassung , wie sie aus US 5,404,142 (A-dams et al.) bekannt ist. Anstelle einer Anordnung zur zyklischen Rotation ist in dieser Schaltungsanordnung eine Anordnung zum rausch-formenden Verwürfeln (Noise Shaped Scrambling) 21 angeordnet. Das thermometer-codierte Signal X bzw. dessen Signalkomponenten x0, x1, ..., x²ⁿ-1 werden dabei durch eine Verwürfelungs-Schaltung geführt, welche das Rauschen formt, welches aus der Element-Fehlanpassung der 1-Bit-Digital-zu-Analog-Umsetzer 3 resultiert. Das Rauschen wird dabei in einer Art und Weise geformt, dass die Rauschenergie bei niedrigeren Frequenzen reduziert wird und bei höheren Frequenzen, welche außerhalb des interessierenden Bandes liegen, angehoben wird. Dies bewirkt eine deutliche Verbesserung des inbandigen Signal-zu-Rausch-Verhältnisses.

Ein vergleichbarer rausch-formender digitaler Element-Anpassungseffekt kann auch mit einer Schaltungsanordnung gemäß Fig.7 bzw. gemäß US 5,684,482 (Galton) erzielt werden, dies jedoch mit größerer Hardware-Effizienz. Bei dieser Anordnung wird der Codierer 2 gemäß Fig.4 durch einen Verwürfelungs-Codierer mit einer Baumstruktur 22 ersetzt, welcher entsprechende höherwertige codierte Signalkomponenten x0, x1, ..., x2ⁿ-1 an die Vielzahl der 1-Bit-Digital-zu-Analog-Umsetzer-Elemente 3 ausgibt. Der Thermometer-Codierer und die rauschformende Verwürfelungs-Funktionalität werden dabei in einer baumstrukturierten Codierungs-Anordnung kombiniert.

Ein weiteres Verfahren zur digitale Element-Anpassung ist bekannt aus US 6,384,761 (Melanson), wobei jedes Eingangssignal der 1-Bit-Digital-zu-Analog-Umsetzer-Elemente über einen Integrator zweiter oder höherer Ordnung zu einem Vektor-Quantisierer zurückgeführt wird, dem das Ausgangssignal eines Mehr-Bit-Delta-Sigma-Modulators als ein zweites Eingangssignal zugeführt wird. Der Vektor-Quantisierer arbeitet entsprechend vorgegebenen Regeln und steuert die Aktivierung der 1-Bit-Digital-zu-Analog-Umsetzer-Elemente von den Ausgängen bzw. Ausgangssignalen der Integratoren und dem Ausgang bzw. Ausgangssignal des Delta-Sigma-Modulators. Ein Rauschformer besteht dabei aus einem anfänglichen Verzögerungselement und zwei kaskadierend angeordneten Integratoren.

Die Aufgabe der Erfindung besteht darin, eine alternative und einfache Schaltungsanordnung bzw. ein entsprechendes Verfahren zum Linearisieren mit digitaler Element-Anpassung bzw. Digital-zu-Analog-Umsetzer-Anpassung vorzuschlagen.

Diese Aufgabe wird durch eine Linearisierungs-Schaltungsanordnung mit den Merkmalen des Patentanspruchs 1 bzw. durch ein Linearisierungs-Verfahren mit den Merkmalen des Patentanspruchs 10 gelöst.

Vorteilhafte Ausgestaltungen sind Gegenstand von abhängigen Ansprüchen.

Bevorzugt wird demgemäss eine Linearisierungs-Schaltungsanordnung mit digitaler Element-Anpassung für Digital-zu-Analog-Umsetzer mit einem n-Bit-Delta-Sigma-Modulator zum Bereitstellen eines modulierten n-Bit-Signals mit einer Gesamtanzahl von Bit, mit einem Codierer, an dem das modulierte n-Bit-Signal anliegt und der ein codiertes Signal mit einer Vielzahl von Signalkomponenten bereitstellt, mit einer Vielzahl von Digital-zu-Analog-Umsetzer-Elementen, insbesondere je einem Digital-zu-Analog-Umsetzer-Element pro Signalkomponente, wobei jedem der Digital-zu-Analog-Umsetzer-Elemente eine der Signalkomponenten anliegt und jedes der Digital-zu-Analog-Umsetzer-Elemente eine analoge Signalkomponente ausgibt, und mit einem Analogsignal-Akkumulator zum Addieren der analogen Signalkomponenten zu einem analogen Ausgangssignal. Vorteilhaft wird diese Anordnung durch eine Wichtungsfaktor-Bereitstellungseinrichtung zum Bereitstellen eines ersten Wichtungsfaktors für aktivierte der Digital-zu-Analog-Umsetzer-Elemente und zum Bereitstellen eines zweiten Wichtungsfaktors für nicht-aktivierte der Digital-zu-Analog-Umsetzer-Elemente.

Bevorzugt wird insbesondere eine Schaltungsanordnung, bei der an der Wichtungsfaktor-Bereitstellungseinrichtung die Gesamtanzahl und eine Aktiv-Anzahl aktivierter der modulierten n-Bit-Signale anliegt. Bevorzugt wird insbesondere eine solche Schaltungsanordnung, bei der die Wichtungsfaktor-Bereitstellungseinrichtung ausgestaltet ist, zum Bereitstellen des ersten Wichtungsfaktors für aktivierte der Digital-zu-Analog-Umsetzer-Elemente'als der Gesamtanzahl der Aktiv-Anzahl und zum Bereitstellen des zweiten Wichtungsfaktors für nicht-aktivierte der Digital-zu-Analog-Umsetzer-Elemente als der negativen Aktiv-Anzahl.

Bevorzugt wird insbesondere eine Schaltungsanordnung nach einem vorstehenden Anspruch, bei der eine Schalteinrichtung je einen Schalter pro codierter Signalkomponente aufweist, wobei jedem der Schalter als Schaltsignal eine der codierten Signalkomponenten oder ein davon abhängiges Signal anliegt und jeder der Schalter geschaltet ist, je nach Zustand der anliegenden der Signalkomponenten bzw. des diesbezüglichen Signals entweder den ersten oder den zweiten Wichtungsfaktor als geschaltetem Signal auszugeben. Bevorzugt wird insbesondere eine solche Schaltungsanordnung, bei der jedem der Schalter ein Integrator oder Akkumulator nachgeschaltet ist. Bevorzugt wird insbesondere eine solche Schaltungsanordnung, bei der einem Prioritäts-Selektor die geschalteten und gegebenenfalls integrierten Signale anliegen, wobei der Prioritäts-Selektor ausgelegt ist, damit ein Steuersignal für den Codierer bereitzustellen. Bevorzugt wird insbesondere eine solche Schaltungsanordnung, bei welcher der Codierer ausgelegt ist, Digital-zu-Analog-Umsetzer-Elemente entsprechend der Aktiv-Anzahl aktiver der modulierten n-Bit-Signale abhängig vom Steuersignal auszuwählen zum Anlegen an aktive Digital-zu-Analog-Umsetzer mit der geringsten Fehlersumme an den Akkumulator. Bevorzugt wird insbesondere eine solche Schaltungsanordnung, bei welcher der Prioritäts-Selektor und der Codierer geschaltet und ausgelegt sind, für jedes der Digital-zu-Analog-Umsetzer-Elemente über die Zeit gemittelt einen integrierten, normierten, gewichteten Fehler anzulegen.

Bevorzugt wird insbesondere eine Schaltungsanordnung, bei welcher der Codierer ausgelegt ist, die codierten Signalkomponenten in Abhängigkeit von dem ersten und/oder dem zweiten Wichtungsfaktor gewichtet an den entsprechenden Digital-zu-Analog-Umsetzern anzulegen.

Bevorzugt wird demgemäss ein Linearisierungs-Verfahren mit digitaler Element-Anpassung für Digital-zu-Analog-Umsetzer, bei dem ein moduliertes n-Bit-Signal mit einer Gesamtanzahl von Bit bereitgestellt wird, bei dem ein codiertes Signal mit einer Vielzahl von Signalkomponenten abhängig vom modulierten n-Bit-Signal bereitgestellt wird, bei dem mittels eines jeweiligen Digital-zu-Analog-Umsetzer-Elements jeweils eine analoge Signalkomponente zu den codierten Signalkomponenten bereitgestellt wird und bei dem die analogen Signalkomponenten zu einem analogen Ausgangssignal addiert werden, wobei ein erster Wichtungsfaktor für aktivierte der codierten Signale und ein zweiter Wichtungsfaktor für nicht-aktivierte der codierten Signale bereitgestellt wird.

Bevorzugt wird insbesondere ein Verfahren, bei dem der erste und der zweite Wichtungsfaktor mittels einer Gesamtanzahl der modulierten n-Bit-Signale und einer Aktiv-Anzahl aktivierter der modulierten n-Bit-Signale erzeugt werden. Bevorzugt wird insbesondere ein solches Verfahren, bei dem der erste Wichtungsfaktor erzeugt wird durch Subtraktion der Aktiv-Anzahl k von der Gesamtanzahl n gemäß W+ = n - k und der zweite Wichtungsfaktor bereitgestellt wird als der Wert der negativen Aktiv-Anzahl k gemäß W- = -k.

Bevorzugt wird insbesondere ein Verfahren, bei dem abhängig vom Zustand einer jeden der Signalkomponenten jeweils ein geschaltetes Signal mit dem Wert entweder des ersten oder des zweiten Wichtungsfaktors bereitgestellt wird. Bevorzugt wird insbesondere ein solches Verfahren, bei dem die geschalteten Signale über die Zeit integriert werden. Bevorzugt wird insbesondere ein solches Verfahren, bei dem mittels der Gesamtheit der geschalteten und gegebenenfalls integrierten Signale ein Steuersignal für einen Codierer zum Bereitstellen der codierten Signalkomponenten bereitgestellt wird. Bevorzugt wird insbesondere ein solches Verfahren, bei dem durch den Codierer mittels des Steuersignals die codierten Signalkomponenten derart ausgewählt angesteuert werden, dass entsprechend der Anzahl aktiver der modulierten n-Bit-Signale entsprechende analoge Signalkomponenten aktivierter Digital-zu-Analog-Umsetzer zum Ausgangssignal akkumuliert werden.

Bevorzugt wird insbesondere ein Verfahren, bei dem die codierten Signalkomponenten mittels des Steuersignals derart codiert werden, dass für jeden Digital-zu-Analog-Umsetzer über die Zeit gemittelt ein integrierter, normierter, gewichteter Fehler angelegt wird.

Bevorzugt wird insbesondere ein Verfahren, bei dem die codierten Signale in Abhängigkeit von dem ersten und/oder dem zweiten Wichtungsfaktor gewichtet für die Analog-zu-DigitalUmsetzung verwendet werden.

Ein Ausführungsbeispiel wird nachfolgend anhand der Zeichnung näher erläutert. Es zeigen:
- Fig. 1: eine beispielhafte Linearisierungs-Schaltungsanordnung mit digitaler Element-Anpassung für eine Vielzahl einzelner Digital-zu-Analog-Umsetzer-Elemente,
- Fig. 2: ein Ausgangssignal eines acht-stufigen Digital-Analog-Umsetzers mit Thermometer-Codierer und ohne Fehlanpassungs-Formung nach Anwendung einer schnellen Fourier-Transformation gemäß einem Simulationsergebnis mit einer 1%-igen rms-Fehlanpassung mit einem Signal-zuRausch-Verhältnis von 80 dB,
- Fig. 3: ein solches Diagramm mit einer Fehlanpassungs-Formung gemäß einem bevorzugten Ausführungsbeispiel und einem Signal-zu-Rausch-Verhältnis von 104 dB,
- Fig. 4: eine Linearisierungs-Schaltungsanordnung mit einem Thermometer-Codierer und einer Vielzahl einzelner Digital-zu-Analog-Umsetzer-Elemente gemäß dem Stand der Technik,
- Fig. 5: eine solche Schaltungsanordnung mit einer Verwürfelungsschaltung zum zyklischen Rotieren codierter Signale gemäß dem Stand der Technik,
- Fig. 6: eine solche Schaltungsanordnung mit einer Verwürfelungsanordnung zum Rauschformen und
- Fig. 7: eine solche Schaltungsanordnung mit einem Verwürfelungs-Codierer mit Baumstruktur.

Wie aus Fig.1 ersichtlich, besteht eine Linearisierungs-Schaltungsanordnung zum Durchführen eines Linearisierungs-Verfahrens gemäß besonders einer bevorzugten Ausführungsform aus einer Vielzahl einzelner Komponenten, welche vorzugsweise durch eine entsprechende Strukturierung in einem VLSI ausgebildet werden. Prinzipiell sind auch alternative Ausbildungen durch beispielsweise eigenständige Baukomponenten für die verschiedenen dargestellten Komponenten umsetzbar. Auch hinsichtlich der Stufigkeit bzw. der Gesamtanzahl codierter Signalkomponenten sind Variationen möglich, insbesondere auch Variationen im Verhältnis der Gesamtanzahl codierter Signalkomponenten zu der Gesamtanzahl modulierter n-Bit-Signale und 1-Bit-Digital-zu-Analog-Umsetzer-Elemente. Die 1-Bit-Digital-zu-Analog-Umsetzer werden nachfolgend als 1-Bit-Digital-zu-Analog-Umsetzer-Elemente bezeichnet, um eine begriffliche Unterscheidbarkeit zu der Gesamtkonstruktion zu vereinfachen, welche einen Digital-zu-Analog-Umsetzer ausbildet.

Fig. 1 stellt eine allgemein bekannte Architektur eines Digital-zu-Analog-Umsetzers DAC dar. Ein n-Bit-Delta-Sigma-Modulator 1, an dessen Eingang ein digitales Eingangssignal i anliegt, gibt an seinem Ausgang ein moduliertes n-Bit-Signal in mit einer Gesamtanzahl n von Bit aus. Dieses modulierte n-Bit-Signal in ist einem Eingang eines speziellen Codierers 2 angelegt. Der Codierer 2 erzeugt ein 2ⁿ-1-Bit-Signal als ein höherwertiges codiertes Signal X mit 2ⁿ-1 Signalkomponenten x0, x1, x2, ..., x2ⁿ-1, welche auf entsprechenden Ausgangsleitungen bereitgestellt werden. Jede der Ausgangsleitungen führt zu einem eigenen 1-Bit-Digital-zu-Analog-Umsetzer-Element 3, welches den Wert der eingangsseitigen Signalkomponente des codierten Signals X in eine entsprechende analoge Signalkomponente a0, a1, a2, ..., a2ⁿ-1 umsetzt und über einen Ausgang einem Addierer bzw. Akkumulator 4 anlegt. Der Akkumulator 4 addiert die anliegenden analogen Signalkomponenten a0, a1, ..., a2ⁿ-1 zu einem analogen Ausgangssignal A, welches aus der Schaltungsanordnung ausgegeben wird.

Gemäß einer besonders bevorzugten Ausführungsform der Linearisierungs-Schaltungsanordnung bzw. des Linearisierungs-Verfahrens ist zusätzlich zu diesen Komponenten bzw. Verfahrensschritten eine Anordnung aus einer Wichtungsfaktor-Bereitstellungseinrichtung 5, einer Schalteinrichtung 6, einer Vielzahl von Integratoren in einer Integratoreinrichtung 7 und einem Prioritätsselektor 8 bereitgestellt. Mit diesen werden die codierten Signalkomponenten x0, x1, ..., x2ⁿ-1 abhängig von einem ersten Wichtungsfaktor W+ für aktivierte Digital-Analog-Umsetzer-Elemente 3 und einem zweiten Wichtungsfaktor W- für nicht-aktivierte Digital-Analog-Umsetzer-Elemente 3 angesteuert bzw. aufbereitet.

Für die digitale Element-Anpassung bzw. die Anpassung der einzelnen codierten Signale x0, x1, ...., x2ⁿ-1 für die einzelnen 1-Bit-Digital-zu-Analog-Umsetzer-Elemente 3 werden entsprechend die beiden datenabhängigen Wichtungsfaktoren W+, W- für die Element-Fehlanpassung bestimmt bzw. berechnet. Der erste dieser Wichtungsfaktoren W+ wird bereitgestellt für ein aktiviertes 1-Bit-Digital-zu-Analog-Umsetzer-Element 3 bzw. zur Bereitstellung von dessen entsprechendem codierten Signal x0, x1, ..., x2ⁿ-1. Der zweite Wichtungsfaktor W- wird für die nicht-aktivierten 1-Bit-Digital-zu-Analog-Umsetzer-Elemente 3 bzw. zum Bereitstellen von deren codierten Signalen x0, x1, ..., x2ⁿ-1 bereitgestellt. Der Einfluss des Fehlers eines bestimmten der als 1-Bit-Digital-zu-Analog-Umsetzer bzw. Umsetzer-Elemente 3 auf den Gesamt-Digital-zu-Analog-Umsetzer-Fehler im Ausgangssignal A ist dabei abhängig von einer Aktiv-Anzahl k als der Anzahl aktiver codierter Signale bzw. aktiver 1-Bit-Digital-zu-Analog-Umsetzer-Elemente 3.

Diese Abhängigkeit kann anhand eines einfachen Beispiels eines 3-Bit-Digital-zu-Analog-Umsetzers veranschaulicht werden, wobei jedem der drei 1-Bit-Digital-zu-Analog-Umsetzer-Elemente 3 die normierte Wichtung von 1 plus einem individuellen Fehlanpassungsfehler e0, e1, e2 zugeordnet wird. Für die drei entsprechenden 1-Bit-Digital-zu-Analog-Umsetzer-Elemente folgen daraus die Werte als 1 + e0, 1 + e1 bzw. 1 + e2.

Verfahrensgemäß kann für alle möglichen digitalen Eingangs-Code das analoge Ausgangssignal A erzeugt werden. Die digitalen Eingangs-Code werden entsprechend dabei durch drei codierte Signale x0, x1, x2 repräsentiert. Durch Abbilden des Codes 000 auf -1 und des Codes 111 auf +1 als einen normierten Bereich für den Gesamt-Digital-zu-Analog-Umsetzer kann ein entsprechend bestimmter normierter Fehler f bestimmt werden, wie dies in der beispielhaften Tabelle veranschaulicht ist.

**Tabelle:**

| x2 | x1 | x0 | A | Abbildung m | normierter Fehler f |
|---|---|---|---|---|---|
| 0 | 0 | 0 | 0 | -1 | 0 |
| 0 | 0 | 1 | 1 + e0 | -1/3 | -e2 - e1 + 2*e0 |
| 0 | 1 | 0 | 1 + e1 | -1/3 | -e2 + 2*e1 - e0 |
| 0 | 1 | 1 | 2 + e0 + e1 | +1/3 | -2*e2 + e1 + e0 |
| 1 | 0 | 0 | 1 + e2 | -1/3 | 2*e2 + e1 - e0 |
| 1 | 0 | 1 | 2 + e0 + e2 | +1/3 | e2 + 2*e1 + e0 |
| 1 | 1 | 0 | 2 + e1 + e2 | +1/3 | e2 + e1 - 2*e0 |
| 1 | 1 | 1 | 3 + e0 + e1 + e2 | +1 | 0 |

Die Tabelle gibt in den ersten drei Spalten einer jeder Zeile die entsprechenden Werte der codierten Signale x2, x1, x0 wieder, wobei diese beispielsweise entweder den Wert 0 oder den Wert 1 aufweisen. Daraus folgt je nach Code in der vierten Spalte der entsprechende Wert des analogen Ausgangssignals A. Die fünfte Spalte gibt die entsprechende Abbildung m wieder und die sechste Spalte den entsprechenden normierten Fehler f. Gemäß der ersten Zeile mit dem Code 000 folgt für das analoge Ausgangssignal A ein Wert 0, welcher auf den Wert m = -1 abgebildet wird und einen normierten Fehler f = 0 hat, da keiner der 1-Bit-Digital-zu-Analog-Umsetzer 3 aktiviert wurde und entsprechend kein Fehlereinfluss zu verzeichnen ist. Die zweite Zeile zeigt den Fall des Codes 001 mit der ersten der codierten Signalkomponenten x0 in aktivem Zustand mit einem Wert 1. Für das analoge Ausgangssignal A folgt A = 1 + e0. Die Abbildung erfolgt auf m = -1/3. Der normierte Fehler bestimmt sich zu f = -e2 + (-e1) + 2*e0. In entsprechender Art und Weise werden in den nachfolgenden Zeilen die entsprechenden Werte für die verschiedenen möglichen Code angegeben.

Die Tabelle zeigt, dass jeder individuelle Fehler der einzelnen 1-Bit-Digital-zu-Analog-Umsetzer-Elemente 3 eine zueinander verschiedene normierte Wichtung abhängig von der Anzahl aktivierter Elemente aufweist. Außerdem ist ersichtlich, dass die normierte Wichtung für einen n-stufigen Digital-zu-Analog-Umsetzer DAC gemäß nachfolgender Ausführungen generalisierbar ist.

Falls ein Digital-zu-Analog-Umsetzer DAC eine Gesamtanzahl von n 1-Bit-Digital-zu-Analog-Umsetzer-Elementen 3 aufweist und von diesen eine Aktiv-Anzahl k von Elementen aktiviert ist, das heißt k <= m gilt, dann folgt für die normierte Wichtung des Fehlers f eine Wichtungs-Möglichkeit mit dem ersten und mit dem zweiten Wichtungsfaktor W+, W-. Für ein aktiviertes Element ist der Wichtungsfaktor W+ gleich der Differenz aus der Gesamtanzahl n und der Aktiv-Anzahl k, das heißt es gilt W+ = n - k. Der zweite Wichtungsfaktor W- für die nicht-aktivierten Elemente entspricht der negativen Aktiv-Anzahl k, das heißt es gilt W- = -k. Dieses Abbildungsverhältnis ist aus einem Vergleich der ersten drei Spalten mit der letzten Spalte der Tabelle gut erkennbar.

Zur Umsetzung der in der Schaltungsanordnung gemäß Fig.1 werden der erste und der zweite.Wichtungsfaktor W+, W- in der Wichtungsfaktor-Bereitstellungseinrichtung 5 entsprechend bestimmt und bereitgestellt. Die Schaltungsanordnung mit auch den weiteren Komponenten stellt zum Kompensieren des Fehlanpassungs-Fehlers sicher, dass die integrierten normierten gewichteten Fehler über die Zeit betrachtet für jeden der 1-Bit-Digital-zu-Analog-Umsetzer gleich Null ist. Dies ist von der Auswirkung her äquivalent zu einem Rausch-Formen des Fehlanpassungs-Fehlers.

Gemäß einer einfachen Ausführungsform besteht die Wichtungsfaktor-Bereitstellungseinrichtung 5 aus einem Multiplikator 50, an dessen Eingängen der Wert der Aktiv-Anzahl k und der Faktorisierungs-Wert -1 anliegen. Der Wert der Aktiv-Anzahl k wird bereitgestellt als die Anzahl von Leitungen bzw. modulierten n-Bit-Signalen in mit aktivem Signal auf den Leitungen. Außerdem weißt die Wichtungsfaktor-Bereitstellungseinrichtung 5 einen Addierer 51 auf, an dessen einen Eingang der Wert der Gesamtanzahl n der modulierten n-Bit-Signale in bzw. entsprechender Leitungen angelegt ist. An einem weiteren Eingang ist der Ausgangswert des Multiplikators 50, das heißt der Wert -k angelegt. Der Ausgangswert -k des Multiplikators 50 wird am Ausgang der Wichtungsfaktor-Bereitstellungseinrichtung 5 als der zweite Wichtungsfaktor W-= -k bereitgestellt. Der Ausgangswert des Addierers 51 wird als der erste Wichtungsfaktor W+ für aktive Elemente bereitgestellt mit W+ = n - k.

Die beiden Wichtungsfaktoren W+, W- werden der Schalteinrichtung 6 zugeführt. Die Schalteinrichtung 6 besteht aus einer Vielzahl von Schaltern S0, S1, ..., S2ⁿ-1, an deren jeweils zwei Schalteingängen der erste bzw. der zweite Wichtungsfaktor W+, W- anliegen. Gesteuert werden die Schalter S0, ..., S2ⁿ-1 mittels jeweils einem eigenen Schaltsignal, welches dem Zustand einer der codierten Signalkomponenten x0, ..., x2ⁿ-1 entspricht. Dabei ist jedem der Schalter S0, ..., S²ⁿ-1 ein-eindeutig eine der codierten Signalkomponenten x0, ..., x2ⁿ-1 zugeordnet. Befindet sich eine der Signalkomponenten x0, ...., x2ⁿ-1 in aktivem Zustand, schaltet der zugeordnete Schalter S0, ..., S2ⁿ-1 auf den Schalteingang, an dem der erste Wichtungsfaktor W+ anliegt. Anderenfalls schaltet der zugeordnete Schalter S0, ...., S2ⁿ-1 auf den Eingang, an dem der zweite Wichtungsfaktor W- anliegt. Je nach Schaltstellung gibt jeder der Schalter S0, S1, ..., S2ⁿ-1 entsprechend entweder den ersten oder den zweiten Wichtungsfaktor W+, W- an seinem Schaltausgang aus.

Die Integratoreinrichtung 7 besteht aus einer Vielzahl einzelner Integratoren I0, I1, ..., I2ⁿ-1. Anstelle einer solchen Integratoreinrichtung 7 kann beispielsweise auch eine andere Akkumulierungs-Einrichtung eingesetzt werden. Jeder der einzelnen Integratoren I0, I1, ..., I2ⁿ-1 besteht aus einem eingangsseitigen Addierer 70, an dessen jeweiligem Ausgang ein Verzögerungs-Element 71, z^{-m} angeschlossen ist. Der Ausgangswert des Verzögerungs-Elements wird einem Eingang des vorgeschalteten Addierers 70 zugeführt.

Dem zweiten Eingang des Addierers 70 wird der Ausgangswert eines diesem Integrator I0, ..., I²ⁿ-1 ein-eindeutig zugeordneten der Schalter S0, S1, ..., S2ⁿ-1 angelegt. Die Ausgangswerte der Verzögerungs-Elemente 71 aller der einzelnen Integratoren I0, I1, ..., I2ⁿ-1 werden dem Prioritäts-Selektor 8 zugeführt.

Der Prioritäts-Selektor 8 ermittelt als Prioritätsdecoder, an welchem Akkumulatorausgang der aktuell größte Fehler anliegt. Das von dem Prioritäts-Selektor 8 entsprechend dieser gewonnenen Information bestimmte und bereitgestellte Prioritäts-Signal ps wird dem als ein Code-Generator ausgebildeten Codierer 2 zu dessen Steuerung angelegt. Der Codierer 2 entscheidet davon abhängig, welche der 1-Bit-DAC-Elemente 3 im folgenden Zyklus berücksichtigt werden und welche nicht. Somit werden große Fehler zuerst korrigiert und der Gesamt-Fehler wird schneller zu Null.

Gemäß dieser Ausführungsform wird somit der normierte gewichtete Fehler für jeden der 1-Bit-Digital-zu-Analog-Umsetzer 3 in einem der Integratoren I0, I1, ..., I2ⁿ-1 der Integratoreinrichtung 7 akkumuliert. Die akkumulierten Werte werden in den Prioritäts-Selektor 8 eingegeben. Der Prioritäts-Selektor 8 stellt Steuersignale bzw. das Prioritäts-Signal ps für den Codierer 2 bereit. Falls an dem Eingang des Codierers 2 das n-Bit-Eingangssignal mit dem Wert k aktiver Signale bzw. Leitungen anliegt, dann werden durch den Codierer 2 dieser Aktiv-Anzahl k entsprechend entsprechende Digital-zu-Analog-Umsetzer-Elemente aus den 2ⁿ-1 der 1-Bit-Digital-zu-Analog-Umsetzer-Elemente 3 derart ausgewählt, dass diejenigen der mit dem Akkumulator 4 verbundenen 1-Bit-Digital-zu-Analog-Umsetzer-Elemente 3 mit der geringsten Summe bzw. Fehlersumme aktiviert werden.

Fig. 2 zeigt das Ergebnis einer Fourier-Transformation auf simulierte Daten eines acht-stufigen Digital-zu-Analog-Umsetzers mit einem Thermometer-Codierer gemäß dem Stand der Technik ohne eine Fehlanpassungs-Formung mit 1% rms Fehlanpassung und einem Signal-zu-Rausch-Verhältnis von 80 dB.

Fig.3 zeigt ein Diagramm zu entsprechenden Daten, wobei ein Verfahren gemäß dem bevorzugten Ausführungsbeispiel zur Fehlanpassungs-Formung angewendet wurde. Dadurch ist ein Signal-zu-Rausch-Verhältnis von 104 dB erzielbar, so dass die vorteilhafte Wirkung der Verfahrensweise bzw. der Schaltungsanordnung deutlich erkennbar ist.

## Patentansprüche

1. Linearisierungs-Schaltungsanordnung mit digitaler Element-Anpassung für Digital-zu-Analog-Umsetzer (3) mit
- einem n-Bit-Delta-Sigma-Modulator (1) zum Bereitstellen eines modulierten n-Bit-Signals (in) mit einer Gesamtanzahl (n) von Bit,
- einem Codierer (2), an dem das modulierte n-Bit-Signal (in) anliegt und der ein codiertes Signal (X) mit einer Vielzahl (2ⁿ-1) von Signalkomponenten (x0, x1, ..., x2ⁿ-1) bereitstellt,
- einer Vielzahl von Digital-zu-Analog-Umsetzer-Elementen (3), insbesondere je einem Digital-zu-Analog-Umsetzer-Element (3) pro Signalkomponente (x0, x1, ..., x2ⁿ-1), wobei jedem der Digital-zu-Analog-Umsetzer-Elemente eine der Signalkomponenten anliegt und jedes der Digital-zu-Analog-Umsetzer-Elemente eine analoge Signalkomponente (a0, a1, ..., a2ⁿ-1) ausgibt, und
- einem Analogsignal-Akkumulator (4) zum Addieren der analogen Signalkomponenten zu einem analogen Ausgangssignal (A),
**gekennzeichnet durch**
eine Wichtungsfaktor-Bereitstellungseinrichtung (5) zum Bereitstellen eines ersten Wichtungsfaktors (W+) für aktivierte der Digital-zu-Analog-Umsetzer-Elemente (3) und zum Bereitstellen eines zweiten Wichtungsfaktors (W-) für nicht-aktivierte der Digital-zu-Analog-Umsetzer-Elemente (3).

2. Schaltungsanordnung nach Anspruch 1, bei der an der Wichtungsfaktor-Bereitstellungseinrichtung (5) die Gesamtanzahl (n) und eine Aktiv-Anzahl (k) aktivierter der modulierten n-Bit-Signale (in) anliegt.

3. Schaltungsanordnung nach Anspruch 2, bei die Wichtungsfaktor-Bereitstellungseinrichtung (5) ausgestaltet ist, zum Bereitstellen des ersten Wichtungsfaktors (W+ = n - k) für aktivierte der Digital-zu-Analog-Umsetzer-Elemente (3) als der Gesamtanzahl (n) der Aktiv-Anzahl (k) und zum Bereitstellen des zweiten Wichtungsfaktors (W- = -k) für nicht-aktivierte der Digital-zu-Analog-Umsetzer-Elemente (3) als der negativen Aktiv-Anzahl (k).

4. Schaltungsanordnung nach einem vorstehenden Anspruch, bei der eine Schalteinrichtung (6) je einen Schalter (S0, ..., S2ⁿ-1) pro codierter Signalkomponente (x0, x1, ..., x2ⁿ-1) aufweist, wobei jedem der Schalter als Schaltsignal eine der codierten Signalkomponenten oder ein davon abhängiges Signal anliegt und jeder der Schalter geschaltet ist, je nach Zustand der anliegenden der Signalkomponenten bzw. des diesbezüglichen Signals entweder den ersten oder den zweiten Wichtungsfaktor (W+, W-) als geschaltetem Signal auszugeben.

5. Schaltungsanordnung nach Anspruch 4, bei der jedem der Schalter (S0, S1, ..., S2ⁿ-1) ein Integrator (I1, I2, ..., I²ⁿ-1) oder Akkumulator nachgeschaltet ist.

6. Schaltungsanordnung nach Anspruch 4 oder 5, bei der einem Prioritäts-Selektor (8) die geschalteten und gegebenenfalls integrierten Signale anliegen, wobei der Prioritäts-Selektor ausgelegt ist, damit ein Steuersignal (ps) für den Codierer (2) bereitzustellen.

7. Schaltungsanordnung nach Anspruch 6, bei welcher der Codierer (2) ausgelegt ist, Digital-zu-Analog-Umsetzer-Elemente (3) entsprechend der Aktiv-Anzahl (k) aktiver der modulierten n-Bit-Signale (in) abhängig vom Steuersignal (ps) auszuwählen zum Anlegen an aktive Digital-zu-Analog-Umsetzer (3) mit der geringsten Fehlersumme an den Akkumulator (4).

8. Schaltungsanordnung nach Anspruch 6 oder 7, bei welcher der Prioritäts-Selektor (8) und der Codierer (2) geschaltet und ausgelegt sind, für jedes der Digital-zu-Analog-Umsetzer-Elemente (3) über die Zeit gemittelt einen integrierten, normierten, gewichteten Fehler (e0, e1, ..., e2ⁿ-1) anzulegen.

9. Schaltungsanordnung nach einem vorstehenden Anspruch, bei welcher der Codierer (2) ausgelegt ist, die codierten Signalkomponenten (x0, ..., x2ⁿ-1) in Abhängigkeit von dem ersten und/oder dem zweiten Wichtungsfaktor (W+, W-) gewichtet an den entsprechenden Digital-zu-Analog-Umsetzern (3) anzulegen.

10. Linearisierungs-Verfahren mit digitaler Element-Anpassung für Digital-zu-Analog-Umsetzer, bei dem
- ein moduliertes n-Bit-Signal (in) mit einer Gesamtanzahl (n) von Bit bereitgestellt wird,
- ein codiertes Signal (X) mit einer Vielzahl von Signalkomponenten (x0, x1, ..., x2ⁿ-1) abhängig vom modulierten n-Bit-Signal bereitgestellt wird,
- mittels eines jeweiligen Digital-zu-Analog-Umsetzer-Elements (3) jeweils eine analoge Signalkomponente (a0, a1, ..., a2ⁿ-1) zu den codierten Signalkomponenten bereitgestellt wird und
- die analogen Signalkomponenten zu einem analogen Ausgangssignal (A) addiert werden,
**dadurch gekennzeichnet, dass**
- ein erster Wichtungsfaktor (W+) für aktivierte der codierten Signal komponenten (x0, x1, ..., x2ⁿ-1) und
- ein zweiter Wichtungsfaktor (W-) für nicht-aktivierte der codierten Signal komponenten bereitgestellt wird.

11. Verfahren nach Anspruch 10, bei dem der erste und der zweite Wichtungsfaktor (W+, W-) mittels einer Gesamtanzahl (n) des modulierten n-Bit-Signals (in) und einer Aktiv-Anzahl (k) aktivierter des modulierten n-Bit-Signals erzeugt werden.

12. Verfahren nach Anspruch 11, bei dem
- der erste Wichtungsfaktor erzeugt wird durch Subtraktion der Aktiv-Anzahl k von der Gesamtanzahl n gemäß W+ = n - k und
- der zweite Wichtungsfaktor bereitgestellt wird als der Wert der negativen Aktiv-Anzahl gemäß W- = -k.

13. Verfahren nach einem der Ansprüche 10 bis 12, bei dem abhängig vom Zustand einer jeden der Signalkomponenten (x0, x1, ..., x2ⁿ-1) jeweils ein geschaltetes Signal mit dem Wert entweder des ersten oder des zweiten Wichtungsfaktors (W+, W-) bereitgestellt wird.

14. Verfahren nach Anspruch 13, bei dem die geschalteten Signale über die Zeit integriert werden.

15. Verfahren nach Anspruch 13 oder 14, bei dem mittels der Gesamtheit der geschalteten und gegebenenfalls integrierten Signale ein Steuersignal (ps) für einen Codierer (2) zum Bereitstellen der codierten Signalkomponenten (x0, x1, ..., x2ⁿ-1) bereitgestellt wird.

16. Verfahren nach Anspruch 15, bei dem durch den Codierer (2) mittels des Steuersignals (ps) die codierten Signalkomponenten derart ausgewählt angesteuert werden, dass entsprechend der Anzahl (k) aktiver der modulierten n-Bit-Signale (in) entsprechende analoge Signalkomponenten (a0, a1, ..., a2ⁿ-1) aktivierter Digital-zu-Analog-Umsetzer (3) zum Ausgangssignal (A) akkumuliert werden.

17. Verfahren nach Anspruch 15 oder 16, bei dem die codierten Signalkomponenten mittels des Steuersignals (ps) derart codiert werden, dass für jeden Digital-zu-Analog-Umsetzer (3) über die Zeit gemittelt ein integrierter, normierter, gewichteter Fehler (e0, e1, ..., e2ⁿ-1) angelegt wird.

18. Verfahren nach einem der Ansprüche 10 bis 17, bei dem die codierten Signale in Abhängigkeit von dem ersten und/oder dem zweiten Wichtungsfaktor gewichtet für die Analog-zu-DigitalUmsetzung verwendet werden.

## Claims

1. Linearisation circuit arrangement with digital element matching for digital-to-analogue converters (3), comprising:
- an n-bit delta-sigma modulator (1) for providing a modulated n-bit signal (in) comprising a total number (n) of bits,
- an encoder (2) to which the modulated n-bit signal (in) is applied and which provides an encoded signal (X) comprising a plurality (2ⁿ-1) of signal components (x0, x1, ..., x2ⁿ-1),
- a plurality of digital-to-analogue converter elements (3), in particular one digital-to-analogue converter element (3) per signal component (x0, x1, ..., x2ⁿ-1), wherein one of the signal components is applied to each of the digital-to-analogue converter elements and each of the digital-to-analogue converter elements outputs an analogue signal component (a0, a1, ..., a2ⁿ-1), and
- an analogue signal adder (4) for adding the analogue signal components to form an analogue output signal (A),
**characterised by** a weighting factor supply device (5) for providing a first weighting factor (W+) for activated digital-to-analogue converter elements (3) and for providing a second weighting factor (W-) for non-activated digital-to-analogue converter elements (3).

2. Circuit arrangement according to claim 1, in which the total number (n) and an active number (k) of activated modulated n-bit signals (in) are applied to the weighting factor supply device (5).

3. Circuit arrangement according to claim 2, in which the weighting factor supply device (5) is designed to provide the first weighting factor (W+ = n-k) for activated digital-to-analogue converter elements (3) as the total number (n) [lacuna] the active number (k) and to provide the second weighting factor (W- = -k) for non-activated digital-to-analogue converter elements (3) as the negative active number (k).

4. Circuit arrangement according to a preceding claim, in which a switching device (6) has one switch (S0, ..., S2ⁿ-1) per encoded signal component (x0, x1, ..., x2ⁿ-1), wherein one of the encoded signal components or a signal dependent thereon is applied to each of the switches as a switching signal and each of the switches is switched depending on the state of the applied signal component or the associated signal so as to output as the switched signal either the first or the second weighting factor (W+, W-).

5. Circuit arrangement according to claim 4, in which an integrator (I1, I2, ..., I2ⁿ-1) or adder is connected downstream of each of the switches (S0, S1, ..., S2ⁿ-1).

6. Circuit arrangement according to claim 4 or 5, in which the switched and optionally integrated signals are applied to a priority selector (8), wherein the priority selector is designed to provide a control signal (ps) for the encoder (2).

7. Circuit arrangement according to claim 6, in which the encoder (2) is designed to select digital-to-analogue converter elements (3) according to the active number (k) of active modulated n-bit signals (in) depending on the control signal (ps), for application to active digital-to-analogue converters (3) with the lowest error sum on the adder (4).

8. Circuit arrangement according to claim 6 or 7, in which the priority selector (8) and the encoder (2) are switched and are designed to apply in a time-averaged manner an integrated, normalised, weighted error (e0, e1, ..., e2ⁿ-1) to each of the digital-to-analogue converter elements (3).

9. Circuit arrangement according to a preceding claim, in which the encoder (2) is designed to apply the encoded signal components (x0, ..., x2ⁿ-1) in a weighted manner, as a function of the first and/or second weighting factor (W+, W-), to the corresponding digital-to-analogue converter elements (3).

10. Linearisation method with digital element matching for digital-to-analogue converters, in which:
- a modulated n-bit signal (in) comprising a total number (n) of bits is provided,
- an encoded signal (X) comprising a plurality of signal components (x0, x1, ..., x2ⁿ-1) is provided as a function of the modulated n-bit signal,
- in each case an analogue signal component (a0, a1, ..., a2ⁿ-1) for the encoded signal components is provided by means of a respective digital-to-analogue converter element (3), and
- the analogue signal components are added to form an analogue output signal (A),
**characterised in that**
- a first weighting factor (W+) is provided for activated encoded signal components (x0, x1, ..., x2ⁿ-1), and
- a second weighting factor (W-) is provided for non-activated encoded signal components.

11. Method according to claim 10, in which the first and the second weighting factor (W+, W-) are produced by means of a total number (n) of modulated n-bit signals (in) and an active number (k) of activated modulated n-bit signals.

12. Method according to claim 11, in which
- the first weighting factor is produced by subtracting the active number k from the total number n so that W+ = n-k, and
- the second weighting factor is provided as the value of the negative active number so that W- = -k.

13. Method according to one of claims 10 to 12, in which, depending on the state of each of the signal components (x0, x1, ..., x2ⁿ-1), in each case a switched signal having the value of either the first or the second weighting factor (W+, W-) is provided.

14. Method according to claim 13, in which the switched signals are integrated over time.

15. Method according to claim 13 or 14, in which all of the switched and optionally integrated signals are used to provide a control signal (ps) for an encoder (2) for providing the encoded signal components (x0, x1, ..., x2ⁿ-1).

16. Method according to claim 15, in which the encoded signal components are selected by the encoder (2) by means of the control signal (ps) in such a way that, depending on the number (k) of active modulated n-bit signals (in), corresponding analogue signal components (a0, a1, ..., a2ⁿ-1) of activated digital-to-analogue converters (3) are added to form the output signal (A).

17. Method according to claim 15 or 16, in which the encoded signal components are encoded by means of the control signal (ps) in such a way that an integrated, normalised, weighted error (e0, e1, ..., e2ⁿ-1) is applied in a time-averaged manner to each digital-to-analogue converter (3).

18. Method according to one of claims 10 to 17, in which the encoded signals are used in a weighted manner, as a function of the first and/or the second weighting factor, for the digital-to-analogue conversion.

## Revendications

1. Circuit de linéarisation avec adaptation d'éléments numériques pour des convertisseurs numériques/analogiques (3) comprenant :
- un modulateur delta-sigma à nbits (1), fournissant un signal modulé à nbits (in) ayant un nombre total (n) de bits,
- un codeur (2) recevant le signal modulé à nbits (in) et fournissant un signal codé (X) ayant un grand nombre (2ⁿ-1) de composantes de signal (x0,x1...,x2ⁿ-1),
- un grand nombre d'éléments de convertisseurs numériques/ analogiques (3) notamment un élément de convertisseur numérique/ analogique (3) pour chaque composante de signal (x0,x1...,x2ⁿ-1), et à chacun des éléments de convertisseur numérique/analogique est appliqué une composante de signal et chacun des éléments convertisseurs numériques/analogiques fournit une composante analogique de signal (a0, a1... a2ⁿ-1), et
- un accumulateur de signaux analogiques (4) pour additionner les composantes de signal analogique et former un signal analogique de sortie (A),
**caractérisé par**
une installation de fourniture de coefficients de pondération (5) pour fournir un premier coefficient de pondération (w+) pour les éléments de conversion numérique/analogique (3), activés, et pour fournir un second coefficient de pondération (w-) pour les éléments de convertisseur numérique/analogique (3) non activés.

2. Circuit selon la revendication 1,
selon lequel
l'installation de fourniture de coefficients de pondération (5) reçoit le nombre total (n) et un nombre actif (k) de signaux à nbits (in) modulés, activés.

3. Circuit selon la revendication 1,
selon lequel
l'installation de fourniture de coefficients de pondération (5) est arrêtée pour fournir un premier coefficient de pondération (w+= n-k) pour les éléments de convertisseur numérique/analogique (3), activés, comme nombre total (n) du nombre activé (k) et pour fournir le second coefficient de pondération (w-=-k) pour les éléments de convertisseur numérique/analogique (3) non activés comme nombre négatif activé (k).

4. Circuit selon l'une des revendications précédentes,
selon lequel
une installation de commutation (6) comporte un commutateur (SO, S1... S2ⁿ-1), pour chaque composante de signal codé (x0,x1...,x2ⁿ-1) et chaque commutateur reçoit comme signal de commutation l'une des composantes de signal codé ou un signal qui en dépend et chacun des commutateurs est commuté pour fournir selon l'état des composantes de signaux appliquées ou du signal correspondant soit le premier, soit le second coefficient de pondération (w+, w-) comme signal commuté.

5. Circuit selon la revendication 4,
selon lequel
chaque commutateur (SO, S1... S2ⁿ-1), est suivi d'un intégrateur (I1, I2..., I2ⁿ-1) ou d'un accumulateur.

6. Circuit selon la revendication 4 ou 5,
selon lequel
un sélecteur de priorité (8) reçoit les signaux commutés et, le cas échéant, intégrés,
le sélecteur de priorité étant conçu pour fournir un signal de commande (ps) pour le codeur (2).

7. Circuit selon la revendication 6,
selon lequel
le codeur (2) est réalisé pour sélectionner des éléments de convertisseur numérique/analogique (3) en fonction du nombre actif (k) de signaux à nbits (in), modulés, activés, en fonction du signal de commande (ps) pour les appliquer à des convertisseurs numériques/analogiques (3) activés, avec la somme minimale d'erreurs minimales à l'accumulateur (4).

8. Circuit selon la revendication 6 ou 7,
selon lequel
le sélecteur de priorité (8) et le codeur (2) sont branchés et conçus pour appliquer à chacun des éléments de convertisseur numérique/ analogique (3), une erreur (e0, e1... e2ⁿ-1), intégrée, normée, pondérée, prise en moyenne dans le temps.

9. Circuit selon l'une des revendications précédentes,
selon lequel
le codeur (2) est conçu pour pondérer les composantes de signaux codés (x0,x1...,x2ⁿ-1) en fonction du premier et/ou du second coefficient de pondération (w+, w-) pour les appliquer aux convertisseurs numériques/analogiques (3) correspondants.

10. Procédé de linéarisation avec adaptation d'éléments numériques pour des convertisseurs numériques/analogiques (3) selon lequel :
- on fournit un signal à nbits (in) modulé ayant un nombre total (n) de bits,
- un signal codé (X) est fourni avec de multiples composantes de signal (x0,x1...,x2ⁿ-1) en fonction du signal à nbits, modulé,
- à l'aide d'un élément de convertisseur numérique/analogique respectif (3), on fournit chaque fois une composante de signal analogique (a0, a1... a2ⁿ-1), pour les composantes de signaux codés et
- on additionne les composantes de signaux analogiques pour obtenir un signal de sortie analogique (A),
**caractérisé en ce qu'**
- on fournit un premier coefficient de pondération (w+) pour les composantes de signaux codés activés (x0, x1...,x2ⁿ-1), et
- un second coefficient de pondération (w-) pour les composantes de signaux codés non activés.

11. Procédé selon la revendication 10,
selon lequel
on génère le premier et le second coefficient de pondération (w+, w-) à l'aide d'un nombre total (n) de signaux à nbits (in), modulés, et un nombre actif (k) de signaux à nbits, modulés, activés.

12. Procédé selon la revendication 11,
selon lequel
- on génère le premier coefficient de pondération par soustraction du nombre actif (k) par rapport au nombre total (n) selon la relation (w+=n-k) et
- on fournit le second coefficient de pondération comme valeur du nombre actif négatif selon la relation (w-=-k).

13. Procédé selon l'une des revendications 10 à 12,
selon lequel
en fonction de l'état de chacune des composantes de signal (x0, x1...,x2ⁿ-1), on fournit chaque fois un signal commuté avec la valeur soit du premier, soit du second coefficient de pondération (w+, w-).

14. Procédé selon la revendication 13,
selon lequel
on intègre les signaux commutés en fonction du temps.

15. Procédé selon la revendication 13 ou 14,
selon lequel
à l'aide de l'ensemble des signaux commutés et, le cas échéant, intégrés, on fournit un signal de commande (ps) pour un codeur (2) pour fournir des composantes de signaux codés (x0, x1...,x2ⁿ-1).

16. Procédé selon la revendication 15,
selon lequel
par le codeur (2), à l'aide du signal de commande (ps), on commande la sélection des composantes de signaux codés de façon qu'en fonction du nombre (k) de signaux à nbits (in) modulés, actifs, on accumule de façon correspondante des composantes de signal analogique (a0, a1... a2ⁿ-1)" des convertisseurs numériques/analogiques (3), activés, pour obtenir le signal de sortie (A).

17. Procédé selon la revendication 15 ou 16,
selon lequel
on code les composantes de signaux codés à l'aide du signal de commande (ps) de façon que chaque convertisseur numérique/ analogique (3) reçoive une erreur (e0, e1... e2ⁿ-1)., intégrée, normée, pondérée et correspondant à une moyenne dans le temps.

18. Procédé selon l'une des revendications 10 à 17,
selon lequel
on utilise, pour la conversion analogique/numérique, les signaux codés en fonction du premier et/ou du second coefficient de pondération.
